# EUROPÄISCHE PATENTSCHRIFT

(11) **EP 1 046 891 B1**
(45) Veröffentlichungstag und Bekanntmachung des Hinweises auf die Patenterteilung: **11.12.2002**
(21) Anmeldenummer: 00106538.2
(22) Anmeldetag: 27.03.2000
(51) Int. Cl.: G01L 1/22, G01L 3/10, G01R 17/00, H01C 17/24

(54) **Vorrichtung zum Abgleichen einer Messbrückenschaltung und Drehmomentmesswelle**
Device for trimming a measuring bridge and rotating shaft for measuring a torsional moment
Dispositif d' équilibrage d' un pont de mesure et arbre tournant de mesure de couple de torsion

(30) Priorität: 17.04.1999 DE 19917443
(43) Veröffentlichungstag der Anmeldung: 25.10.2000
(73) Patentinhaber: Siemens Aktiengesellschaft, 80333 München (DE)
(72) Erfinder: Langner, Frank, 64521 Gross-Gerau (DE); Mattmann, Erich, 55262 Heidesheim (DE)

(56) Entgegenhaltungen:
- DD-A- 109 466
- DE-A- 2 555 226
- DE-A- 2 724 817
- DE-A- 3 544 984
- US-A- 4 505 032

## Beschreibung

Die Erfindung betrifft eine Vorrichtung zum Abgleichen einer Meßbrückenschaltung mit wenigstens zwei auf einem Substrat aufgedruckten schichtartigen elektrischen Abgleichwiderständen mit ebenfalls aufgedruckten Anschlußkontakten, deren Widerstandswerte zum Abgleich der Brückenschaltung durch Einschnitte in das Widerstandsmaterial veränderbar sind, sowie eine Drehmomentmeßwelle.

In Anordnungen zur Messung der elastischen Dehnung mechanischer Bauteile, wie sie beispielsweise zur Überwachung des Torsionsmoments an Lenksäulen in Kraftfahrzeugen verwendet werden, kommen in zunehmendem Maße sogenannte Dickschichtwiderstände zum Einsatz. Derartige Widerstände werden auf das betreffende Bauteil inklusive der kompletten Verdrahtung aufgedruckt und sind daher sehr einfach und preiswert in großen Mengen herstellbar. Aufgrund von Fertigungstoleranzen müssen Möglichkeiten zum Abgleichen der aufgedruckten Schaltungen vorgesehen werden. Der an den Schaltungen, meist handelt es sich um Wheatstonebrücken, durchzuführende Abgleich wird entweder an den Brückenwiderständen selbst, oder an speziell dafür vorgesehenen Abgleichwiderständen durchgeführt.

Es ist möglich, den Widerstandswert eines derartigen aufgedruckten Widerstandselementes zu verändern, indem die Widerstandsschicht mit Hilfe eines Lasers eingeschnitten wird, wodurch sich der für den Stromfluß zur Verfügung stehende Querschnitt verengt. Die durch das Schneiden auftretenden Effekte lassen sich gut mit dem Stromlinienmodell beurteilen. In diesem Modell verfolgt man die Bahnen der im Material fließenden Elektronen. Aus der Beeinflussung der elektrischen Stromlinien durch das Schneiden kann auf die Änderungen des elektrischen Widerstands geschlossen werden. (DE 27 24 817 A2) Gemäß dieser Entgegenhaltung verlaufen die gedachten elektrischen Stromlinien im abgeglichenen Zustand entlang einer mittleren Richtung.

Aufgabe der vorliegenden Erfindung ist es, eine Vorrichtung anzugeben, welche preiswert herstellbar und platzsparend ist und einen genauen Abgleich ermöglicht.

Bei einer ersten Ausführungsform der Erfindung ist vorgesehen, daß wenigstens ein Abgleichwiderstand im wesentlichen eine längliche Grundform aufweist, daß ein erster Anschlußkontakt an einem Ende und ein zweiter Anschlußkontakt wenigstens teilweise längs des Abgleichwiderstands angeordnet ist und daß ein Abgleichschnitt im wesentlichen parallel zu und mit geringem Abstand von dem zweiten Anschlußkontakt anzuordnen ist. Durch die Führung des Abgleichschnittes dicht entlang des längs angeordneten Anschlußkontakts wird dieser im Effekt von der Widerstandsschicht abgetrennt. Dadurch steigt der Widerstandswert kontinuierlich mit zunehmender Schnittlänge, ohne daß die Stromlinien starke Verzerrungen erfahren, wodurch sich Nichtlinearitäten im Widerstandsverhalten ergäben. Lediglich die mittlere Richtung der gedachten Stromlinien ändert sich mit zunehmender Schnittlänge.

Dies bedeutet, daß die Stromlinien durch die Schnittführung zwar zur Konvergenz oder Divergenz gezwungen werden können, im Mittel aber nicht um große Winkel umgelenkt werden, sondern entlang einer sich durch die Schnittführung einstellenden mittleren Richtung verlaufen. Damit läßt sich in jedem Zustand des Abgleichens eine im wesentlichen gerade, nicht unterbrochene Linie in der mittleren Richtung zwischen den beiden Anschlußkontakten jedes Widerstands ziehen.

Bei einer nächsten Ausführungsform der Erfindung ist vorgesehen, daß wenigstens ein Abgleichwiderstand durch eine Widerstandsschicht gebildet ist, auf deren einer Seite wenigstens ein Anschlußkontakt und auf der dieser Seite gegenüberliegenden Seite im wesentlichen parallel dazu wenigstens zwei weitere Anschlußkontakte angeordnet sind, wobei die Widerstandsschicht zum Abgleich durch einen Abgleichschnitt in zwei unterschiedlich große Bereiche teilbar ist, so daß sich zwei Widerstände unterschiedlicher Widerstandswerte ergeben. Diese Ausführungsform der Erfindung ist neben dem Einsatz als Spannungsabgleicher einer Brückenschaltung auch vorteilhaft zur Spannungsaufteilung verwendbar, indem die beiden Widerstände auf an sich bekannte Weise als Spannungsteiler geschaltet werden.

Bei einer weiteren Ausführungsform der Erfindung ist vorgesehen, daß die geometrische Form wenigstens eines Abgleichwiderstands im unabgeglichenen Zustand aus zwei Bereichen zusammengesetzt ist, daß der erste Bereich derart ausgebildet ist, daß dort die mittlere Länge der gedachten elektrischen Stromlinien zwischen den Anschlußkontakten kleiner ist als die mittlere Breite der Widerstandsschicht und daß der zweite Bereich derart ausgebildet ist, daß dort die mittlere Länge der gedachten elektrischen Stromlinien zwischen den Anschlußkontakten größer ist als die mittlere Breite der Widerstandsschicht.

Eine derartige Form wird bei einer ersten Ausgestaltung der Erfindung dadurch gebildet, daß jeweils ein erster Anschlußkontakt wenigstens eines Abgleichwiderstands diesen an wenigstens zwei Seiten im wesentlichen L- bis C-förmig umgibt, daß der zweite Anschlußkontakt im Innern dieser Form angeordnet ist, wobei er einem kurzen Schenkel des ersten Anschlußkontakts unter Einschluß des unterquadratischen Bereichs im wesentlichen parallel mit einem Abstand gegenübersteht, der geringer ist als die Länge des kurzen Schenkels, und daß der Bereich zwischen den Anschlußkontakten mit Widerstandsmaterial ausgefüllt ist. Zwischen dem zweiten Kontakt und dem kurzen Schenkel entsteht somit ein unterquadratischer Bereich von Widerstandsmaterial und zwischen dem zweiten Kontakt und dem langen Schenkel der L-Form ein überquadratischer. Diese geometrische Form der Widerstände hat sich im Experiment als sehr zweckmäßig erwiesen. Ferner verlaufen die Stromlinien bei dieser Ausgestaltung der Erfindung ohne große Störungen, was die Schnittführung sehr gut kontrollierbar macht. Der Einfluß der Schnittlänge auf die Widerstandsveränderung ist linear, wobei die Steigung im unterquadratischen Bereich gering ist, da der restliche Bereich des Widerstands wie ein parallel geschalteter Widerstand wirkt und somit die Steigung vermindert.

Zum Abgleich des Widerstandswerts kann dabei vorgesehen sein, daß wenigstens in einem Anfangsbereich ein Abgleichschnitt im wesentlichen parallel zu dem kurzen Schenkel verläuft und femer, daß der Abgleichschnitt in einem weiteren, an den Anfangsbereich anschließenden Bereich im wesentlichen parallel zu dem langen Schenkel verläuft.

Die erfindungsgemäßen Abgleichwiderstände weisen neben einem kleinen Grundwiderstand bei dieser Schnittführung eine anfangs recht flache, lineare Kennlinie auf. Damit kann der Widerstandswert in diesem Bereich sehr feinfühlig gesteuert werden, indem der Abgleichschnitt kontinuierlich verlängert wird. Wird der Abgleichschnitt in dem senkrechten Bereich weitergeführt, so wird die Kennlinie etwas steiler, bleibt aber im wesentlichen linear. Damit steht ein großer Einstellbereich zur Verfügung bei relativ kleinem Platzbedarf und hoher Einstellgenauigkeit. Durch die Zusammenschaltung zweier Abgleichwiderstände läßt sich ein Abgleich der betreffenden Schaltung grob mit dem ersten Abgleichwiderstand durchführen, indem der Abgleichschnitt dort bis in den überquadratischen Bereich geführt wird. Der Feinabgleich der Schaltung erfolgt daran anschließend mit dem unterquadratischen Bereich des zweiten Abgleichwiderstands.

Um Platz zu sparen, kann vorgesehen sein, daß zwei Abgleichwiderstände zu einer einzigen Struktur vereinigt sind, indem zwei der Anschlußkontakte der Widerstände zu einem einzigen, zentralen Anschlußkontakt vereinigt sind. Durch diese Maßnahme werden damit aufgebaute Schaltungen erheblich einfacher, da zu jedem Widerstandspaar nicht mehr vier, sondern nur drei Anschlußleitungen geführt werden müssen. Der Platzbedarf sinkt, da die Fläche für einen kompletten Anschiußkontakt und der sonst aus Fertigungsgründen notwendige Zwischenraum zwischen den Widerständen gespart werden kann. Das Widerstandspaar kann ferner aufgrund seiner geringen Ausdehnung als Ganzes in einem dehnungsneutralen Bereich des Bauteils angeordnet werden, weshalb weitere Maßnahmen zur Kompensierung von Störeinflüssen entfallen können.

Zur Messung eines Drehmoments ist bei einer Ausgestaltung der Erfindung vorgesehen, daß wenigstens eine Meßbrückenschaltung aus dehnungsempfindlichen Widerständen auf einer Momentenmeßwelle als Substrat angeordnet ist, daß je Brückenschaltung ein Paar von Abgleichwiderständen nach einem der vorhergehenden Ansprüche in Dickschichttechnik auf dem Substrat aufgedruckt und mit den Brückenschaltungen zum Abgleich verschaltet sind. Die Momentenmeßwelle wird einem zu messenden Drehmoment ausgesetzt. Aus der von den Brückenschaltungen gemessenen Oberflächendehnung der Welle kann auf deren Torsionsverformung und damit auf das anliegende Drehmoment geschlossen werden.

Um Störeinflüsse auf die Abgleichwiderstände durch Dehnung oder Torsion zu mindern, ist bei einer Weiterbildung der Erfindung vorgesehen, daß die Abgleichwiderstände in einem dehnungsneutralen Bereich des Substrats angeordnet sind. im Idealfall sind die Abgleichwiderstände auf der neutralen Faser des zu überwachenden Bauteils angeordnet Ist dies nicht möglich, so können die Abgleichwiderstände auch symmetrisch zur neutralen Faser angeordnet werden, damit Dehnungseinflüsse kompensiert werden. Ferner sind die Abgleichwiderstände aus einem Material zu fertigen, welches gegenüber Dehnung und Temperaturänderungen eine geringe und konstante Empfindlichkeit aufweist.

Um einen schnellen Abgleich zu ermöglichen und gleichzeitig eine geringe Abgleichempfindlichkeit am Ende eines Abgleichschnitts zu gewähren, ist bei einer Weiterbildung der Erfindung vorgesehen, daß die Abgleichwiderstände aus Bereichen unterschiedlicher Widerstandswerte zusammengesetzt sind, wobei die Bereiche vorteilhaft derart angeordnet sein können, daß die Bereichsunterteilung im wesentlichen längs der mittleren Richtung der Stromlinien verläuft. Durch eine derartige Führung des Abgleichschnitts, daß ein Abgleichschnitt nach Durchschneiden eines Bereichs hohen spezifischen Widerstands in einem Bereich niedrigen spezifischen Widerstands endet, kann der gewünschte, am Anfang steile und am Ende flache Verlauf der Schnittlängen-Widerstands-Kennlinie erreicht werden.

Ausführungsbeispiele der Erfindung sind in der Zeichnung anhand mehrerer Figuren dargestellt und in der nachfolgenden Beschreibung näher erläutert.

Es zeigt:
- Fig. 1: eine Brückenschaltung mit herkömmlichen Abgleichwiderständen,
- Fig. 2: eine Brückenschaltung mit einem erfindungsgemäßen Paar von Abgleichwiderständen,
- Fig. 3: eine Drehmomentmeßwelle mit in Dickschichttechnik gedruckter Meßschaltung mit herkömmlichen Abgleichwiderständen,
- Fig. 4: eine Drehmomentmeßwelle mit in Dickschichttechnik gedruckter Meßschaltung mit erfindungsgemäßen Paaren von Abgleichwiderständen,
- Fig. 5: einen herkömmlichen Abgleichwiderstand,
- Fig. 6: erfindungsgemäße einzelne Abgleichwiderstände,
- Fig. 7: ein erfindungsgemäßes Paar von Abgleichwiderständen,
- Fig. 8: einen erfindungsgemäßen einstückigen Abgleichwiderstand,
- Fig. 9: die Kennlinie des Abgleichwiderstands nach Fig. 6a),
- Fig. 10: die Kennlinie des Abgleichwiderstands nach Fig. 6b) und 6c),
- Fig. 11: weitere Ausführungsbeispiele erfindungsgemäßer Abgleichwiderstände,
- Fig. 12: einen Abgleichwiderstand mit zwei verschiedenen Widerstandsmaterialien und
- Fig. 13: die dazu gehörige Schnittlängen-Widerstands-Kennlinie.

Gleiche Teile sind in den Figuren mit gleichen Bezugszeichen versehen.

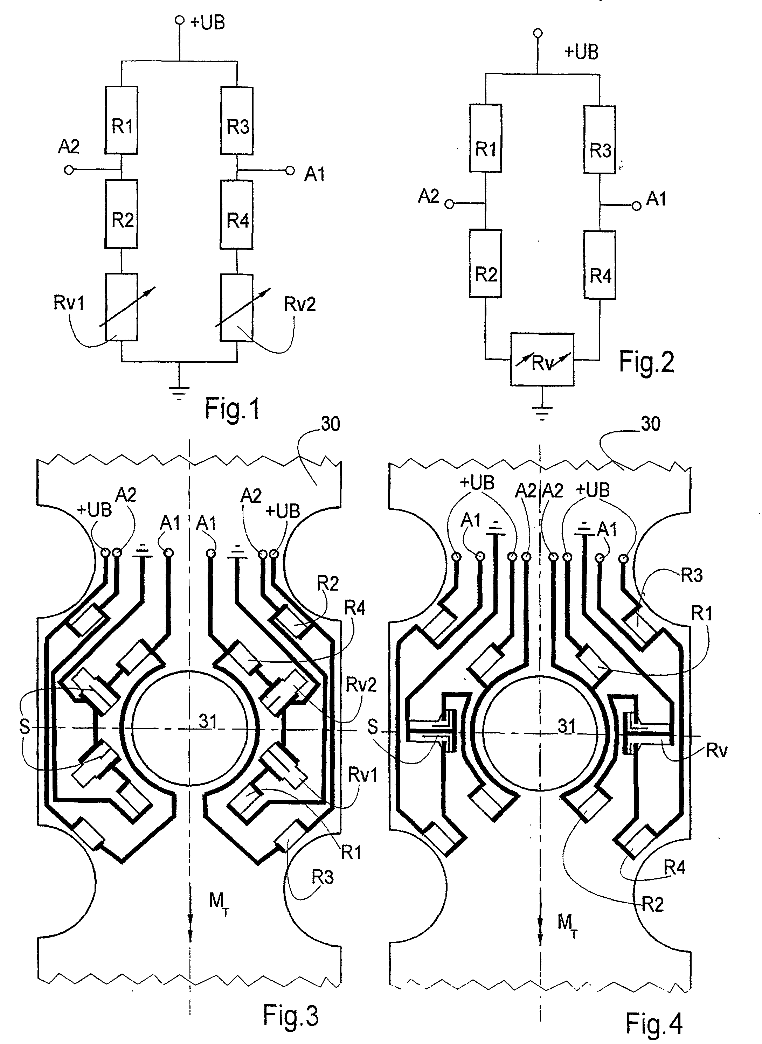

Fig. 1 zeigt eine herkömmliche Brückenschaltung zur Messung von Materialdehnungen, die mit vier dehnungsempfindlichen Widerständen R1 bis R4, sowie mit zwei Abgleichwiderständen Rv1 und Rv2 zum Abgleich der Nullspannung zwischen den Anschlüssen A1 und A2 ausgestattet ist.

In Fig. 2 ist demgegenüber dieselbe Brückenschaltung mit einem erfindungsgemäßen Paar Rv von Abgleichwiderständen dargestellt. Das Widerstandspaar Rv kann auch aus einer einstückigen Widerstandsschicht bestehen, wobei in diesem Fall der Abgleich durch einen einzigen Schnitt für beide Widerstandswerte vorgenommen wird. Das auf einem Substrat aufgedruckte Widerstandsmaterial der Abgleichwiderstände wird zu diesem Zweck mittels eines Laserstrahls entlang der Schnittlinie verdampft.

Fig. 3 zeigt die Anordnung zweier Meßbrücken, bestehend aus dehnungsabhängigen Widerständen R1 bis R4, zur Messung eines Drehmoments MT mit herkömmlichen Hutwiderständen Rv1 und Rv2 als Abgleichwiderständen. Die Schaltung ist auf einer stählernen Torsionswelle 30 mit rechteckigem Querschnitt aufgedruckt. Die Welle wandelt ein Torsionsmoment in eine longitudinale Dehnung der dehnungsabhängigen Widerstände R1 bis R4. Zur Steigerung der Elastizität ist die Welle 30 mit diversen Aussparungen 31 versehen. Zum Abgleich der Meßbrücken werden die Hutwiderstände Rv1 und Rv2 mit Abgleichschnitten S versehen. Die Spannungsverhältnisse der Brückenschaltungen können zum genauen Abgleich während der Schnittführung kontinuierlich gemessen werden. Die Abgleichwiderstände sind zur Kompensierung von Dehnungsbeeinflussungen symmetrisch zu dem dehnungsneutralen Bereich der Welle 30 angeordnet.

In Fig. 4 ist dieselbe Anordnung mit Hilfe zweier erfindungsgemäßer Paare Rv von Abgleichwiderständen verwirklicht. Die Leitungsführung ist hier wesentlich einfacher, als bei Verwendung von Einzelwiderständen. Die Abgleichwiderstände Rv können direkt auf der dehnungsneutralen Faser der Welle angeordnet werden, so daß Dehnungsbeeinflussungen ausgeschlossen sind. Ferner wird hierdurch eine Rißbildung an den Abgleichschnitten S aufgrund von Dauerwechselbelastungen vermieden.

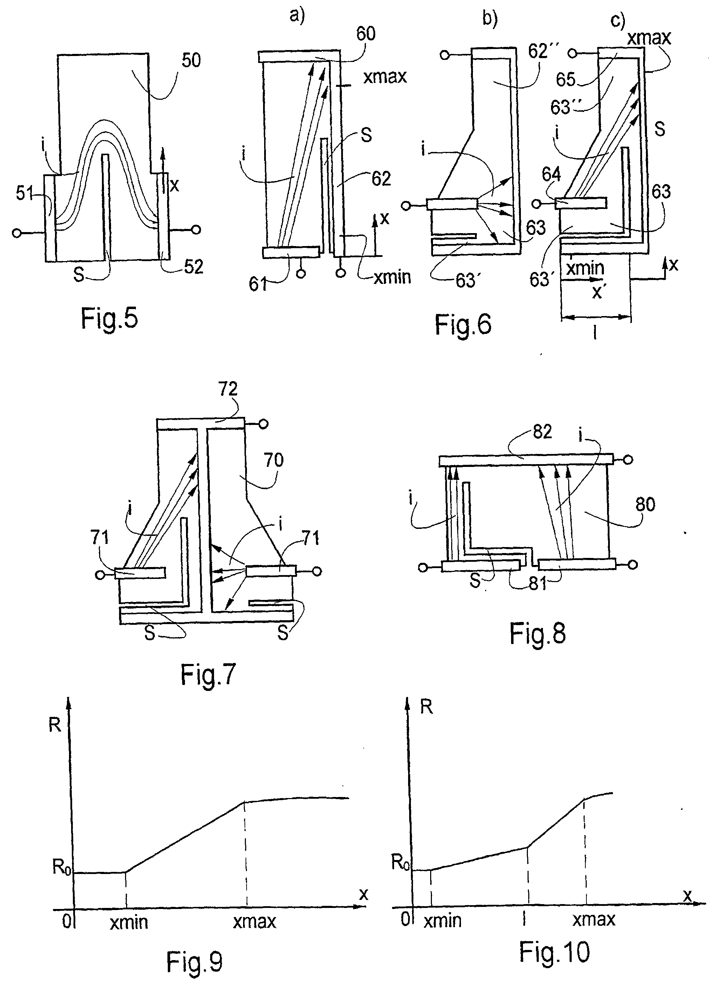

Bei der Verwendung von herkömmlichen Hutwiderständen 50 zum Abgleich der Brückenspannungen wird ein Abgleichschnitt S wie in Fig. 5 geführt. Die Stromlinien i, die sich zwischen den Anschlußkontakten 51, 52 einstellen, werden durch den Abgleichschnitt stark umgelenkt. Die Abhängigkeit des Widerstands von der Schnittlänge x ist dadurch überproportional, was eine genaue Schnittführung erschwert, da eine Verlängerung des Schnitts mit zunehmender Länge x eine immer stärkere Änderung des elektrischen Widerstands der Anordnung bewirkt. Ein derartiger Hutwiderstand beansprucht relativ viel Platz und weist einen hohen Grundwiderstandswert auf.

Bei erfindungsgemäßen Abgleichwiderständen bleiben die sich einstellenden Stromlinien i zwischen den wirksamen Anteilen der Anschlußkontakte 61, 62, bzw. 64, 65 ungestört und richten sich im wesentlichen entlang einer mittleren Richtung aus, deren Lage von der Länge x des Abgleichschnitts S abhängt. Die dazu vorgesehene Anordnung des Widerstandsmaterials 60 zwischen den Anschlußkontakten 61, 62 ist in Fig. 6a) gezeigt. Durch Führung des Abgleichschnitts sehr dicht entlang des längs liegenden Anschlußkontakts 62 wird ein genauer Abgleich ermöglicht, da die Abhängigkeit des Widerstands von der Schnittkoordinate x über nahezu die gesamte Länge des Widerstands 60 linear ist. Der Widerstand 60 beansprucht wenig Platz und weist dafür einen sehr großen Abgleichbereich auf. Seine Temperaturempfindlichkeit ist gering und nahezu unabhängig von der Schnittlänge.

Eine weitere Verbesserung des Abgleichs läßt sich durch eine Anordnung erreichen, wie sie in Fig. 6b) und Fig. 6c) gezeigt ist. Hier besteht der Abgleichwiderstand 65 aus einem unterquadratischen Bereich zwischen den horizontalen Abschnitten der Anschlußkontakte 64 und 65 und einem überquadratischen Bereich längs des langen Schenkels des Anschlußkontakts 65. Im jeweiligen Bereich ist der Einfluß der Länge eines Abgleichschnitts S auf den Widerstand der Gesamtanordnung aus den gleichen Gründen wie oben linear, wobei diese Abhängigkeit in dem unterquadratischen Bereich schwächer ist, als in dem überquadratischen. Zum groben Abgleich wird daher an einem ersten Abgleichwiderstand 63 ein Schnitt gemäß der Fig. 6c) geführt werden. Ein zweiter Abgleichwiderstand 63 wird zum Feinabgleich dann gemäß Fig. 6b) eingeschnitten.

Fig. 7 zeigt zu einem Widerstandspaar zusammengesetzte Abgleichwiderstände 70. Eine derartige Anordnung beansprucht noch weniger Platz als die vorher genannten und kann daher als Ganzes in einem dehnungsneutralen Bereich auf einem zu überwachenden Bauteil angeordnet werden. Ferner vereinfacht sich die Verdrahtung der damit aufgebauten Brückenschaltung erheblich, da nur drei Anschlußleitungen notwendig sind, die an die drei Anschlußkontakte 71, 72 herangeführt werden.

Eine weitere Möglichkeit, den erfindungsgemäß ungestörten Stromlinienverlauf zu erreichen, ist in Fig. 8 dargestellt. Ein einstückiger Widerstand 80, der zwischen parallelen Anschlußkontakten 81, 82 eingebettet ist, ist zum Abgleich an einer vorher bestimmten Stelle eingeschnitten worden. Dadurch entstehen zwei Widerstände unterschiedlicher Widerstandswerte, die die Abgleichwiderstände darstellen. Diese Anordnung kann auf vorteilhafte Weise auch als abgleichbarer Spannungsteiler eingesetzt werden.

In Fig. 9 ist die Kennlinie R(x) des Abgleichwiderstands 60 dargestellt. R bezeichnet den Widerstandswert, x die Länge des Abgleichschnitts S. Zwischen den Koordinaten xmin und xmax verläuft die Kennlinie annähernd linear, so daß hier ein genauer und einfacher Abgleich möglich ist.

Fig. 10 zeigt die Kennlinie des Abgleichwiderstands gemäß Fig. 6b) und Fig. 6c). Zwischen x=0 und I wird der Abgleichschnitt horizontal geführt, zwischen I und xmax vertikal. In dem horizontalen Bereich ist aufgrund des flacheren Kennlinienanstiegs ein feinerer Abgleich möglich, in dem vertikalen Bereich ein stärkerer Abgleich. Die einzelnen Abschnitte der Kennlinie verlaufen annähernd linear.

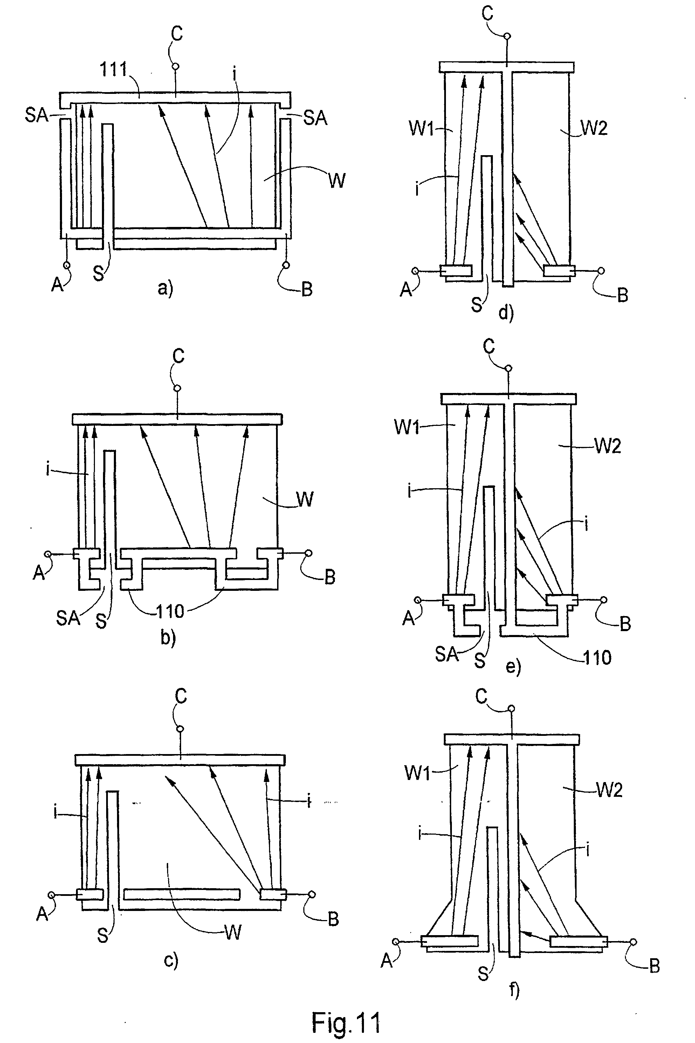

Weitere Ausführungsbeispiele von erfindungsgemäßen Abgleichwiderständen sind in Fig. 11 dargestellt.

Die Figuren 11a) bis 11c) zeigen weitere einstückige Abgleichwiderstände, bei denen die Widerstandsschicht W durch einen geraden Abgleichschnitt in zwei Widerstände unterschiedlicher Widerstandswerte unterteilbar ist. Die Widerstände sind jeweils über die Anschlußkontakte A, B und C mit einer Schaltung verbindbar. Die Stromlinien i verlaufen auch bei diesen Widerständen im wesentlichen entlang einer mittleren Richtung zwischen den jeweiligen Anschlußkontakten.

In Fig. 11a) ist die Widerstandsschicht W von einem, im Rohzustand ringförmigen Leiter 111 umgeben, der durch Laserschnitte SA in die Anschlußkontakte A, B und C unterteilbar ist. Bei dem Widerstand der Fig. 11b) sind Leiterschlaufen 110 vorgesehen, die an den für mögliche Abgleichschnitte vorgesehenen Stellen angeordnet sind und durch Trennschnitte SA geteilt werden können, so daß die Anschlußkontakte A und B entstehen. Die Schlaufen ermöglichen es, den Schnitt durch das leitende Material der Anschlußkontakte mit höherer Laserleistung durchzuführen, als es für das Widerstandsmaterial aus Gründen der Genauigkeit des Abgleichs geboten ist. Für den Fall, daß kein Abgleich notwendig ist, werden die Leiterschlaufen nicht durchtrennt.

Die Figuren 11d) bis 11f) zeigen weitere paarweise Abgleichwiderstände, die jeweils aus zwei modifizierten Widerständen gemäß Fig. 6a) bestehen. Die beiden Widerstandselemente W1 und W2 jedes paarweisen Widerstands sind durch einen zentral angeordneten Anschlußkontakt miteinander zu einem Paar verbunden. Der Abgleichwiderstand der Fig. 11e) weist wieder, aus oben genannten Gründen, Leiterschlaufen 110 auf, die zum Abgleich durchtrennt werden.

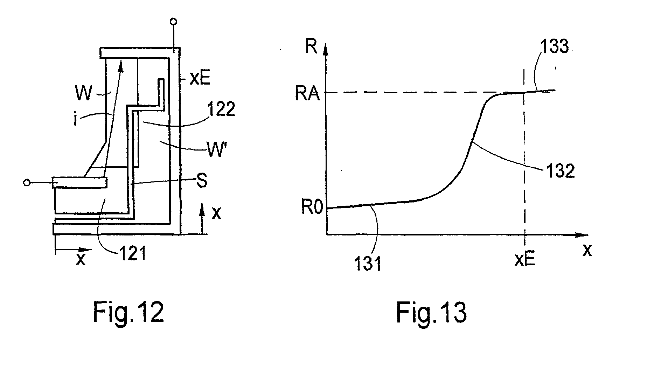

Fig. 12 zeigt einen Abgleichwiderstand, der aus zwei Bereichen W, W' unterschiedlicher Widerstandsmaterialien zusammengesetzt ist. Der Bereich W weist dabei einen zehnfach höheren Widerstandswert auf als der Bereich W'. Der Widerstand selbst weist wieder einen unterquadratischen Bereich 121 und einen überquadratischen Bereich 122 auf. Ein Abgleichschnitt wird so geführt, daß er nach einem Beginn im Bereich 121 den Bereich W durchschneidet, um dort eine hohe Abgleichgeschwindigkeit zu erreichen und kurz vor Erreichen des Abgleichziels in den Bereich W' wechselt, und dort das Abgleichziel weiter ansteuert. Dadurch ist ein sehr feiner Abgleich mit einem einzigen Schnitt möglich.

Fig. 13 zeigt die Widerstands-Kennlinie des in Fig. 12 gezeigten Abgleichwiderstands. Beginnend bei dem Grundwiderstand R0 verläuft die Kennlinie flach im unterquadratischen Bereich (131), um dann zunächst durch das Überwechseln in den überquadratischen Bereich W steiler zu werden (132). Nach Wechseln in den Bereich W' verläuft die Kennlinie wieder flach. Zum Einstellen des Widerstands RA ist der Abgleichschnitt bis zur Stelle xE zu führen.

## Patentansprüche

1. Vorrichtung zum Abgleichen einer Meßbrückenschaltung, mit wenigstens zwei auf einem Substrat aufgedruckten schichtartigen elektrischen Abgleichwiderständen mit ebenfalls aufgedruckten Anschlußkontakten, deren Widerstandswerte zum Abgleich der Brückenschaltung durch Einschnitte in das Widerstandsmaterial veränderbar sind, **dadurch gekennzeichnet, daß** wenigstens ein Abgleichwiderstand (60) im wesentlichen eine längliche Grundform aufweist, daß ein erster Anschlußkontakt (61) an einem Ende und ein zweiter Anschlußkontakt (62) wenigstens teilweise längs des Abgleichwiderstands (60) angeordnet ist und daß ein Abgleichschnitt (S) im wesentlichen parallel zu und mit geringem Abstand von dem zweiten Anschlußkontakt (62) anzuordnen ist.

2. Vorrichtung zum Abgleichen einer Meßbrückenschaltung mit wenigstens zwei auf einem Substrat aufgedruckten schichtartigen elektrischen Abgleichwiderständen mit ebenfalls aufgedruckten Anschlußkontakten, deren Widerstandswerte zum Abgleich der Brückenschaltung durch Einschnitte in das Widerstandsmaterial veränderbar sind, **dadurch gekennzeichnet, daß** wenigstens ein Abgleichwiderstand (80) durch eine Widerstandsschicht (80) gebildet ist, auf deren einer Seite wenigstens ein Anschlußkontakt (82) und auf der dieser Seite gegenüberliegenden Seite im wesentlichen parallel dazu wenigstens zwei weitere Anschlußkontakte angeordnet sind, wobei die Widerstandsschicht (80) zum Abgleich durch einen Abgleichschnitt (S) in zwei unterschiedlich große Bereiche teilbar ist, so daß sich zwei Widerstände unterschiedlicher Widerstandswerte ergeben.

3. Vorrichtung zum Abgleichen einer Meßbrückenschaltung mit wenigstens zwei auf einem Substrat aufgedruckten schichtartigen elektrischen Abgleichwiderständen mit ebenfalls aufgedruckten Anschlußkontakten, deren Widerstandswerte zum Abgleich der Brückenschaltung durch Einschnitte in das Widerstandsmaterial veränderbar sind, **dadurch gekennzeichnet, daß** die geometrische Form wenigstens eines Abgleichwiderstands (63) im unabgeglichenen Zustand aus zwei Bereichen (63', 63'') zusammengesetzt ist, daß der erste Bereich (63') derart ausgebildet ist, daß dort die mittlere Länge der gedachten elektrischen Stromlinien (i) zwischen den Anschlußkontakten (64, 65) kleiner ist als die mittlere Breite (1) der Widerstandsschicht (63) und daß der zweite Bereich (63'') derart ausgebildet ist, daß dort die mittlere Länge der gedachten elektrischen Stromlinien (i) zwischen den Anschlußkontakten (64, 65) größer ist als die mittlere Breite der Widerstandsschicht (63).

4. Vorrichtung nach Anspruch 3, **dadurch gekennzeichnet, daß** jeweils ein erster Anschlußkontakt (65) wenigstens eines Abgleichwiderstands (63) diesen an wenigstens zwei Seiten im wesentlichen L- bis C-förmig umgibt, daß der zweite Anschlußkontakt (64) im Innern dieser Form (65) angeordnet ist, wobei er einem kurzen Schenkel des ersten Anschlußkontakts (65) unter Einschluß des ersten Bereichs (63') im wesentlichen parallel mit einem Abstand gegenübersteht, der geringer ist als die Länge (1) des kurzen Schenkels, und daß der Bereich (63', 63'') zwischen den Anschlußkontakten (64, 65) mit Widerstandsmaterial (63) ausgefüllt ist.

5. Vorrichtung nach Anspruch 4, **dadurch gekennzeichnet, daß** wenigstens in einem Anfangsbereich (63') ein Abgleichschnitt (S) im wesentlichen parallel zu dem kurzen Schenkel verläuft.

6. Vorrichtung nach Anspruch 5, **dadurch gekennzeichnet, daß** der Abgleichschnitt (S) in einem weiteren, an den Anfangsbereich anschließenden Bereich (63") im wesentlichen parallel zu dem langen Schenkel verläuft.

7. Vorrichtung nach einem der vorhergehenden Ansprüche, **dadurch gekennzeichnet, daß** zwei Abgleichwiderstände zu einer einzigen Struktur vereinigt sind, indem zwei der Anschlußkontakte der Widerstände zu einem einzigen, zentralen Anschlußkontakt vereinigt sind.

8. Vorrichtung nach einem der vorhergehenden Ansprüche, **dadurch gekennzeichnet, daß** wenigstens eine Meßbrückenschaltung aus dehnungsempfindlichen Widerständen (R1 bis R4) auf einer Momentenmeßwelle (30) als Substrat angeordnet ist, daß je Brückenschaltung ein Paar (Rv) von Abgleichwiderständen nach einem der vorhergehenden Ansprüche in Dickschichttechnik auf dem Substrat (30) aufgedruckt und mit den Brückenschaltungen zum Abgleich verschaltet sind.

9. Vorrichtung nach einem der vorhergehenden Ansprüche, **dadurch gekennzeichnet, daß** die Abgleichwiderstände in einem dehnungsneutralen Bereich des Substrats (30) angeordnet sind.

10. Vorrichtung nach einem der vorhergehenden Ansprüche, **dadurch gekennzeichnet, daß** die Abgleichwiderstände aus Bereichen (W, W') unterschiedlicher Widerstandswerte zusammengesetzt sind.

11. Vorrichtung nach Anspruch 11, **dadurch gekennzeichnet, daß** die Bereichsunterteilung im wesentlichen längs der mittleren Richtung der Stromlinien verläuft.

12. Vorrichtung nach einem der vorhergehenden Ansprüche 11 oder 12, **dadurch gekennzeichnet, daß** ein Abgleichschnitt nach Durchschneiden eines Bereichs hohen spezifischen Widerstands (W) in einem Bereich niedrigen spezifischen Widerstands (W') endet.

## Claims

1. Device for trimming a measuring bridge circuit having at least two layered electrical trimming resistors which are printed on a substrate, have similarly printed connection contacts and whose resistance values can be varied, for trimming the bridge circuit, by means of cuts in the resistive material, **characterized in that** at least one trimming resistor (60) has an essentially elongate basic shape, **in that** a first connection contact (61) is arranged at one end and a second connection contact (62) is arranged at least partly along the trimming resistor (60), and **in that** a trimming cut (S) is to be arranged essentially parallel to and at a short distance from the second connection contact (62).

2. Device for trimming a measuring bridge circuit having at least two layered electrical trimming resistors which are printed on a substrate, have similarly printed connection contacts and whose resistance values can be varied, for trimming the bridge circuit, by means of cuts in the resistive material, **characterized in that** at least one trimming resistor (80) is formed by a resistive layer (80), with at least one connection contact (82) being arranged on one side of said resistive layer (80) and at least two further connection contacts being arranged on the side opposite this side, essentially parallel to said connection contact (82), and the resistive layer (80) can be divided, for trimming purposes, into two regions of different size by a trimming cut (S), so that two resistors with different resistance values are produced.

3. Device for trimming a measuring bridge circuit having at least two layered electrical trimming resistors which are printed on a substrate, have similarly printed connection contacts and whose resistance values can be varied, for trimming the bridge circuit, by means of cuts in the resistive material, **characterized in that** the geometric shape of at least one trimming resistor (63) is made up of two regions (63', 63'') before trimming has been carried out, **in that** the first region (63') is designed such that, in this region, the mean length of the imaginary electrical flow lines (i) between the connection contacts (64, 65) is less than the mean width (I) of the resistive layer (63), and **in that** the second region (63'') is designed such that, in this region, the mean length of the imaginary electrical flow lines (i) between the connection contacts (64, 65) is greater than the mean width of the resistive layer (63).

4. Device according to Claim 3, **characterized in that** a respective first connection contact (65) of at least one trimming resistor (63) surrounds said trimming resistor (63) on at least two sides essentially in an L to a C shape, **in that** the second connection contact (64) is arranged inside this shape (65) and is opposite and essentially parallel to a short limb of the first connection contact (65), enclosing the first region (63'), at a distance which is less than the length (I) of the short limb, and **in that** the region (63', 63'') between the connection contacts (64, 65) is filled with resistive material (63).

5. Device according to Claim 4, **characterized in that**, at least in an initial region (63'), a trimming cut (S) runs essentially parallel to the short limb.

6. Device according to Claim 5, **characterized in that** the trimming cut (S) runs in a further region (63''), adjoining the initial region, essentially parallel to the long limb.

7. Device according to one of the preceding claims, **characterized in that** two trimming resistors are combined to form a single structure by combining two of the connection contacts of the resistors to form a single, central connection contact.

8. Device according to one of the preceding claims, **characterized in that** at least one measuring bridge circuit comprising strain-sensitive resistors (R1 to R4) is arranged on a moment-measuring shaft (30) as a substrate, **in that**, for each bridge circuit, a pair (Rv) of trimming resistors according to one of the preceding claims is printed on the substrate (30) using thick-layer technology and is connected to the bridge circuits for trimming purposes.

9. Device according to one of the preceding claims, **characterized in that** the trimming resistors are arranged in a strain-neutral region of the substrate (30).

10. Device according to one of the preceding claims, **characterized in that** the trimming resistors are made up of regions (W, W') of different resistance values.

11. Device according to Claim 11, **characterized in that** the division of the regions runs essentially in the mean direction of the flow lines.

12. Device according to one of the preceding Claims 11 and 12, **characterized in that** a trimming cut ends in a region of low specific resistance (W') after cutting through a region of high specific resistance (W).

## Revendications

1. Dispositif d'équilibrage d'un circuit en pont de mesure comprenant au moins deux résistances électriques d'équilibrage en forme de couche appliquées par impression sur un substrat et comportant des contacts de connexion également appliqués par impression, dont les valeurs de résistance peuvent être modifiées, en vue de l'équilibrage du circuit en pont, au moyen de découpes ménagées dans la matière de résistance, **caractérisé en ce qu'**au moins une résistance d'équilibrage (60) présente essentiellement une forme de base allongée, **en ce qu'**un premier contact de connexion (61) est disposé à une extrémité et un second contact de connexion (62) est disposé au moins partiellement le long de la résistance d'équilibrage (60) et **en ce qu'**une découpe d'équilibrage (S) doit être disposée d'une manière essentiellement parallèle au second contact de connexion (62) et à une faible distance de celui-ci.

2. Dispositif d'équilibrage d'un circuit en pont de mesure comprenant au moins deux résistances électriques d'équilibrage en forme de couche appliquées par impression sur un substrat et comportant des contacts de connexion également appliqués par impression, dont les valeurs de résistance peuvent être modifiées, en vue de l'équilibrage du circuit en pont, au moyen de découpes ménagées dans la matière de résistance, **caractérisé en ce qu'**au moins une résistance d'équilibrage (80) est formée au moyen d'une couche de résistance (80), au moins un contact de connexion (82) étant disposé sur un côté de cette couche de résistance (80) et au moins deux autres contacts de connexion disposés sur le côté opposé à ce côté, d'une manière essentiellement parallèle à celui-ci, la couche de résistance (80) pouvant être divisée au moyen d'une découpe d'équilibrage (S), pour l'équilibrage, en deux zones de grandeurs différentes, de sorte qu'il se présente deux résistances à valeurs de résistance différentes.

3. Dispositif d'équilibrage d'un circuit en pont de mesure comprenant au moins deux résistances électriques d'équilibrage en forme de couche appliquées par impression sur un substrat et comportant des contacts de connexion également appliqués par impression, dont les valeurs de résistance peuvent être modifiées, en vue de l'équilibrage du circuit en pont, au moyen de découpes ménagées dans la matière de résistance, **caractérisé en ce que** la forme géométrique d'au moins une résistance d'équilibrage (63) est composée de deux zones (63', 63") à l'état non équilibré, **en ce que** la première zone (63') est réalisée d'une manière telle que, dans celle-ci, la longueur moyenne des lignes de courant électrique imaginaires (i) entre les contacts de connexion (64, 65) est plus petite que la largeur moyenne (I) de la couche de résistance (63) et **en ce que** la seconde zone (63") est réalisée d'une manière telle que, dans celle-ci, la longueur moyenne des lignes de courant électrique imaginaires (i) entre les contacts de connexion (64, 65) est plus grande que la largeur moyenne de la couche de résistance (63).

4. Dispositif suivant la revendication 3, **caractérisé en ce qu'**un premier contact de connexion (65) d'au moins une résistance d'équilibrage (63) entoure chaque fois celle-ci sur au moins deux côtés essentiellement en forme de L à C, **en ce que** le second contact de connexion (64) est disposé à l'intérieur de cette forme (65), en faisant face à une branche courte du premier contact de connexion (65) moyennant l'interposition de la première zone (63'), d'une manière essentiellement parallèle et à une distance qui est plus faible que la longueur (I) de la branche courte, et **en ce que** la zone (63', 63") située entre les contacts de connexion (64, 65) est remplie de la matière de résistance (63).

5. Dispositif suivant la revendication 4, **caractérisé en ce qu'**au moins dans une zone initiale (63'), une découpe d'équilibrage (S) s'étend d'une manière essentiellement parallèle à la branche courte.

6. Dispositif suivant la revendication 5, **caractérisé en ce que** la découpe d'équilibrage (S) s'étend dans une autre zone (63"), adjacente à la zone initiale, d'une manière essentiellement parallèle à la branche longue.

7. Dispositif suivant l'une des revendications précédentes, **caractérisé en ce que** deux résistances d'équilibrage sont réunies en une structure unique, deux des contacts de connexion des résistances étant réunis pour constituer un contact de connexion central unique.

8. Dispositif suivant l'une des revendications précédentes, **caractérisé en ce qu'**au moins un circuit en pont de mesure constitué de résistances (R1 à R4) sensibles à l'allongement est disposé sur un arbre de mesure de couple (30) en tant que substrat, et **en ce que**, pour chaque circuit en pont, une paire (Rv) de résistances d'équilibrage suivant l'une des revendications précédentes sont appliquées par impression sur le substrat (30), suivant la technique à couche épaisse, et sont connectées avec les circuits en pont pour l'équilibrage.

9. Dispositif suivant l'une des revendications précédentes, **caractérisé en ce que** les résistances d'équilibrage sont disposées dans une zone du substrat (30) qui est neutre vis-à-vis de l'allongement.

10. Dispositif suivant l'une des revendications précédentes, **caractérisé en ce que** les résistances d'équilibrage sont composées de zones (W, W') à valeurs de résistance différentes.

11. Dispositif suivant la revendication 11, **caractérisé en ce que** la division de zones s'étend essentiellement le long de la direction moyenne des lignes de courant.

12. Dispositif suivant l'une des revendications 11 ou 12 précédentes, **caractérisé en ce qu'**une découpe d'équilibrage, après le découpage effectué à travers une zone à résistance spécifique élevée (W) se termine en une zone à faible résistance spécifique (W').
